Europäisches Patentamt

European Patent Office

Office européen des brevets

(11) Veröffentlichungsnummer: **0 141 990**
**B1**

(12) **EUROPÄISCHE PATENTSCHRIFT**

(45) Veröffentlichungstag der Patentschrift:
**09.03.88**

(51) Int. Cl.⁴: **H 01 L 23/40**

(21) Anmeldenummer: **84111564.5**

(22) Anmeldetag: **27.09.84**

(54) Einrichtung zum lösbaren Befestigen eines Kühlkörpers auf einem integrierten Baustein.

(30) Priorität: **29.09.83 DE 3335365**

(43) Veröffentlichungstag der Anmeldung:
**22.05.85 Patentblatt 85/21**

(45) Bekanntmachung des Hinweises auf die Patenterteilung:
**09.03.88 Patentblatt 88/10**

(84) Benannte Vertragsstaaten:
**AT BE CH DE FR GB IT LI NL SE**

(56) Entgegenhaltungen:
**GB - A - 902 219**
**US - A - 4 169 642**

(73) Patentinhaber: **Siemens Aktiengesellschaft Berlin und München, Wittelsbacherplatz 2, D-8000 München 2 (DE)**

(72) Erfinder: **Hermann, Adam, Dipl.-Ing. (FH), Massmannstrasse 2, D-8000 München 2 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Einrichtung zum lösbaren Befestigen eines Kühlkörpers auf einem integrierten Baustein und insbesondere auf einem solchen Baustein, bei dem die Anschlüsse des Bausteins auf der Unterseite bis weit an den Rand angeordnet sind.

Für das Befestigen von Kühlkörpern auf Einzelhalbleitern wird entweder die Methode des Festschraubens oder die des Festklemmens durch eine federnde Ausgestaltung des Kühlkörpers selbst häufig angewendet. Aus der GB-A-902 219 ist eine solche federnd ausgestaltete, aufschraubbare Klemmvorrichtung bekannt, bei der ein in einem Gehäuse befindlicher Halbleiter auf eine Kühlplatte gedrückt wird. Der Klemmbügel ist dabei so ausgestaltet, dass er in der Mitte einen kreisförmigen, den Durchmesser des runden Bauteils entsprechenden Ausschnitt aufweist und federnd nach der Mittellinie zu durchgebogen ist. Die beiden Ränder des Bügels sind nach unten ebenfalls abgebogen, und in der Biegung befinden sich zwei Bohrungen, durch die Schrauben hindurchführbar sind. Der Bügel wird über das Gehäuse des Halbleiters gesteckt und durch die Bohrungen mit Schrauben an der Kühlplatte befestigt, so dass durch die Federwirkung des Bügels das Gehäuse des Halbleiters mit seiner Bodenfläche fest auf die Unterlage gedrückt wird. Diese Methoden eignen sich aber nicht für die Befestigung von Kühlkörpern auf integrierten Schaltkreisen, insbesondere solchen mit einer Vielzahl von auf der Unterseite angeordneten Anschlüssen, die in der Regel bis weit an den Rand des Bausteines hin angeordnet sind. Hierfür ist es bekannt, die Kühlkörper unmittelbar auf die Oberseite der integrierten Bausteine zu kleben. Nachteil dieser Methode ist, dass der Kühlkörper nicht ohne Zerstörung vom Baustein gelöst werden kann. Zur lösbaren Befestigung eines Kühlkörpers auf einem integrierten Baustein ist es bekannt geworden, diesen mit Hilfe eines Federbügels von oben her auf den integrierten Baustein zu drücken. Solche bekannte Federbügel bestehen aus Federstahlblech und bewirken damit die Gefahr eines Kurzschlusses der auf der Unterseite des Bausteines bis weit an den Rand hin angeordneten Anschlüsse. Zur Vermeidung dieser Gefahr sind deshalb zwischen dem Federbügel und dem integrierten Baustein noch Isolierstoffteile angeordnet. Dies wiederum hat den Nachteil, dass ausser dem Federbügel noch Isolierstoffteile hergestellt und montiert werden müssen und dass ausserdem der Federbügel seitlich zusätzlichen Platz einnimmt, was bei der hohen Packungsdichte moderner elektronischer Anlagen äusserst unerwünscht ist. Da die bekannten Federbügel zum lösbaren Befestigen eines Kühlkörpers auf einem integrierten Baustein diesen von oben her auf den Baustein drücken, wird auch in der Höhe zusätzlicher Raum durch den Federbügel vergeudet, und der Kühlkörper muss bei einer vorgegebenen Einbauhöhe entsprechend kleiner gemacht werden, was dazu führen kann, dass die Kühlleistung nunmehr nicht ausreichend ist. Der Erfindung lag daher die Aufgabe zugrunde, eine Einrichtung zum lösbaren Befestigen eines Kühlkörpers zu schaffen, die die Nachteile der oben genannten bekannten Einrichtungen vermeidet und ausserdem beim Montieren oder Demontieren des Kühlkörpers keine besonderen Werkzeuge erfordert.

Erfindungsgemäss wird dies erreicht durch einen U-förmig gebogenen Federbügel mit einer mittig angeordneten, etwa dem Kerndurchmesser des Kühlkörpers entsprechenden Öffnung zum Umgreifen des Kühlkörpers zwischen den Kühlrippen, durch mindestens eine Trennfuge zum einseitigen Auseinanderbiegen des Federbügels beim Einführen zwischen die Kühlrippen des Kühlkörpers sowie durch seitlich nach oben ragende Spreizlaschen. Ferner besitzt der U-förmig gebogene Federbügel zwei Paare von an den Schenkelenden des Federbügels angeordneten T-förmigen Ansätzen, die in entsprechend angeordnete rechteckförmige Ausnehmungen an der Seite des integrierten Bausteines bzw. des Stecksockels für den Baustein flach eingreifen.

Weitere vorteilhafte Ausgestaltungen der erfindungsgemässen Einrichtung ergeben sich aus den Unteransprüchen.

Im folgenden wird die Erfindung anhand eines in den Fig. 1 bis 6 dargestellten vorteilhaften Ausführungsbeispiels derselben näher erläutert, wobei

Fig. 1 eine Abwicklung des Federbügels,
Fig. 2 und 3 Seitenansichten des fertig gebogenen Federbügels
Fig. 4 und 5 den montierten Federbügel und
Fig. 6 eine Draufsicht des Sockels für den integrierten Baustein
zeigen.

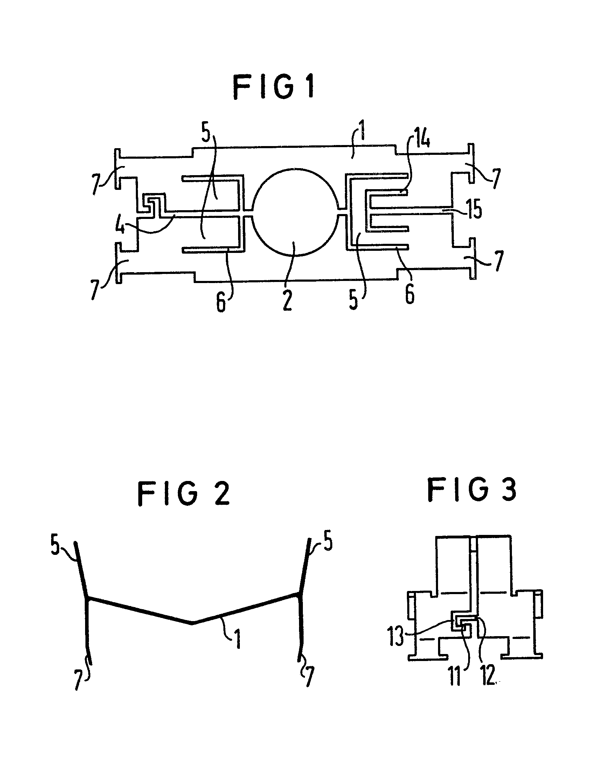

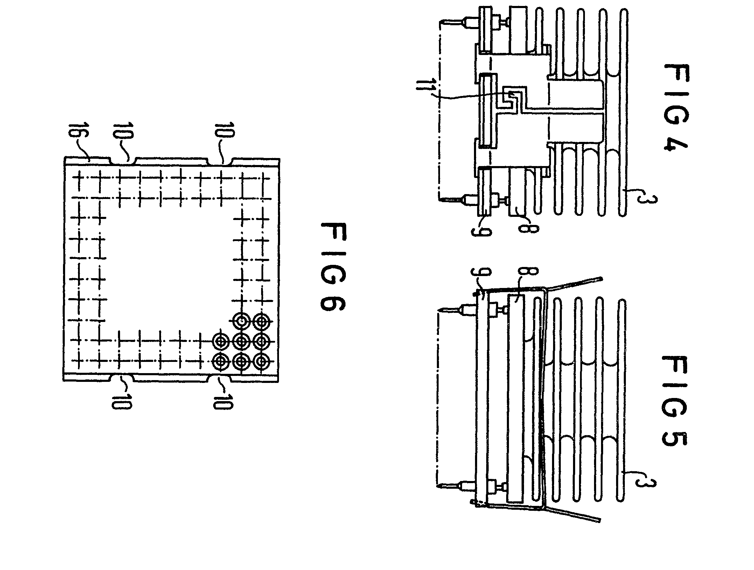

Fig. 1 zeigt die Abwicklung des Federbügels 1. Es ist ersichtlich, dass dieser im wesentlichen eine Rechteckform aufweist und eine etwa mittig angeordnete, etwa dem Kerndurchmesser des Kühlkörpers 3 (Fig. 4, 5) entsprechende Öffnung 2 besitzt. Ferner ist eine Trennfuge 4 vorgesehen, die ein Auseinanderbiegen des Federbügels beim Einführen zwischen die Kühlrippen des Kühlkörpers 3 ermöglicht. In dem Federbügel 1 befinden sich ausserdem U-förmige Schlitze 6, die dazu dienen, nach dem Biegen des Federbügels in die endgültige Form, wie sie Fig. 2 zeigt, sogenannte Spreizlaschen 5 zu bilden.

An den Enden des U-förmigen Federbügels 1 sind zwei Paare von T-förmigen Ansätzen 7 angeordnet, die, wie Fig. 2 und 5 erkennen lassen, nur geringfügig in Richtung auf den integrierten Baustein 8 bzw. den Sockel 9 gebogen sind. Diese T-förmigen Ansätze 7 greifen beim Festklemmen des Kühlkörpers 3 auf dem integrierten Baustein 8 oder dem Sockel 9 in entsprechend angeordnete rechteckförmige Ausnehmungen 10 an der Seite des integrierten Bausteins 8 bzw. des Stecksockels 9 für den Baustein ein, wie aus Fig. 6 zu erkennen ist.

Gemäss einer vorteilhaften Weiterbildung der Erfindung ist auf der teilbaren Seite des Federbügels 1 eine Vorrichtung 11 zum Verschliessen des Federbügels vorgesehen. Diese besteht vorteilhafterweise aus einem an dem einen Schenkel der teilbaren Seite des Federbügels 1 angeordneten L-förmigen Ansatz 12 und einer in dem anderen Schenkel der teilbaren Seite des Federbügels angeordneten L-förmigen Ausnehmung 13, die nach dem Einführen des Federbügels 1 zwischen die Rippen des Kühlkörpers 3 ineinandergreifen und damit die teilbare Seite des Federbügels 1 geschlossen halten.

Um einerseits eine genügende Festigkeit des Federbügels 1 zu erzielen, andererseits aber das Auseinanderbiegen des Federbügels beim Einführen zwischen die Rippen des Kühlkörpers zu erleichtern, ist gemäss einer anderen Weiterbildung der Erfindung in der Spreizlasche 5 der nichtteilbaren Seite des Federbügels 1 ein U-förmiger Schlitz 14 vorgesehen, der parallel zu den Kanten der Spreizlasche 5 verläuft. Dieser U-förmige Schlitz ist verbunden mit einem geradlinigen Schlitz 15, der sich vom entsprechenden Ende des Federbügels mittig bis zu dem U-förmigen Schlitz 14 erstreckt.

Um einen guten Andruck des Kühlkörpers 3 an den integrierten Baustein 8 zu erreichen, ist der Mittelteil des U-förmigen Federbügels 1 in Richtung auf den integrierten Baustein 8 durchgebogen.

Aus Fig. 6 ist schliesslich noch ersichtlich, dass die Oberkanten derjenigen Seiten des integrierten Bausteines 8 oder des Stecksockels 9, in denen die Ausnehmungen für die Aufnahme der T-förmigen Ansätze des Federbügels vorgesehen sind, zur Seite des Kühlkörpers hin abgeschrägt sind. Diese Abschrägungen erleichtern das Einführen der T-förmigen Ansätze 7 in die zugeordneten Ausnehmungen 10.

**Patentansprüche**

1. Einrichtung zum lösbaren Befestigen eines Kühlkörpers auf einem integrierten Baustein, insbesondere einem solchen, bei dem die Anschlüsse auf der Unterseite bis weit an den Rand des Bausteins angeordnet sind, unter Verwendung eines U-förmig gebogenen Federbügels, der eine mittig angeordnete, etwa dem Kerndurchmesser des Kühlkörpers (3) entsprechende Öffnung (2) zum Umgreifen des Kühlkörpers zwischen den Kühlrippen aufweist, dadurch gekennzeichnet, dass der Federbügel mindestens eine Trennfuge (4) zum einseitigen Auseinanderbiegen des Federbügels (1) beim Einführen zwischen die Kühlrippen des Kühlkörpers sowie seitlich nach oben ragende Spreizlaschen (5) aufweist.

2. Einrichtung nach Anspruch 1, dadurch gekennzeichnet, dass die Spreizlaschen (5) durch U-förmige Schlitze (6) in dem Federbügel (1) gebildet sind.

3. Einrichtung nach Anspruch 1, gekennzeichnet durch zwei Paare von an den Schenkelenden des U-förmigen Federbügels angeordneten T-förmigen Ansätzen (7) sowie entsprechend angeordnete rechteckförmige Ausnehmungen (10) an der Seite des integrierten Bausteines (8) bzw. des Stecksockels (9) für den Baustein.

4. Einrichtung nach einem der Ansprüche 1 bis 3, gekennzeichnet durch eine auf der teilbaren Seite des Federbügels angeordnete Vorrichtung (11) zum Verschliessen des Federbügels.

5. Einrichtung nach Anspruch 4, gekennzeichnet durch einen an dem einen Schenkel der teilbaren Seite des Federbügels (1) angeordneten L-förmigen Ansatz (12) und eine in dem anderen Schenkel der teilbaren Seite des Federbügels angeordnete L-förmige Ausnehmung (13), die nach dem Einführen des Federbügels zwischen die Rippen des Kühlkörpers ineinandergreifen und damit die teilbare Seite des Federbügels geschlossen halten.

6. Einrichtung nach einem der Ansprüche 1 oder 2, gekennzeichnet durch einen in der Spreizlasche der nichtteilbaren Seite des Federbügels angeordneten U-förmigen Schlitz (14), der parallel zu den Kanten der Spreizlasche (5) verläuft, sowie einen Schlitz (15), der sich vom entsprechenden Ende des Federbügels mittig bis zu dem U-förmigen Schlitz (14) erstreckt.

7. Einrichtung nach einem der Ansprüche 1 bis 6, dadurch gekennzeichnet, dass der Mittelteil des U-förmigen Federbügels (1) in Richtung auf den integrierten Baustein durchgebogen ist.

8. Einrichtung nach Anspruch 3, dadurch gekennzeichnet, dass die T-förmigen Ansätze (7) an den Schenkelenden des Federbügels geringfügig in Richtung auf den integrierten (8) Baustein gebogen sind.

9. Einrichtung nach einem der Ansprüche 1 bis 8, dadurch gekennzeichnet, dass die Oberkanten (16) derjenigen Seiten des integrierten Bausteines (8) oder des Stecksockels (9), in denen die Ausnehmungen (10) für die Aufnahme der T-förmigen Ansätze (7) des Federbügels vorgesehen sind, zur Seite des Kühlkörpers hin abgeschrägt sind.

**Claims**

1. Device for the detachable mounting of a heat sink on an integrated component, in particular on one of a type in which the connections of the component are arranged on the underside right out to the edge, using a resilient bracket bent in a U-shape which has an opening (2) centrally arranged approximately matching the core diameter of the heat sink (3) for embracing the heat sink between the cooling ribs, characterized in that the resilient bracket has at least one separating slit (4) for bending the resilient bracket apart on one side on introducing it between the cooling ribs of the heat sink, and also spreading flaps (5) projecting laterally upwards.

2. Device according to Claim 1, characterized in that the spreading flaps (5) are formed by U-shaped slits (6) in the resilient bracket (1).

3. Device according to Claim 1, characterized by two pairs of T-shaped extensions (7) arranged at the ends of the legs of the U-shaped resilient bracket and also matchingly arranged rectangular recesses (10) at the side of the integrated component (8) or of the plug socket (9) for the component.

4. Device according to one of the Claims 1 to 3, characterized by a device (11), arranged on the divisible side of the resilient bracket, for locking the resilient bracket.

5. Device acording to Claim 4, characterized by an L-shaped extension (12) arranged on the one leg of the divisible side of the resilient bracket (1) and an L-shaped recess (13) arranged in the other leg of the divisible side of the resilient bracket which, after the introduction of the resilient bracket between the ribs of the heat sink, engage in each other and therefore keep the divisible side of the resilient bracket closed.

6. Device according to one of the Claims 1 or 2, characterized by a U-shaped slit (14), arranged in the spreading flap of the non-divisible side of the resilient bracket, which extends parallel to the edges of the spreading flap (5), and also by a slit (15) which extends from the corresponding end of the resilient bracket centrally up to the U-shaped slit (14).

7. Device according to one of the Claims 1 to 6, characterized in that the central part of the U-shaped resilient bracket (1) is bowed in the direction of the integrated component.

8. Device according to Claim 3, characterized in that the T-shaped extensions (7) at the ends of the legs of the resilient bracket are slightly bent in the direction of the integrated (8) (sic) component.

9. Device according to one of the Claims 1 to 8, characterized in that the upper edge (16) of that side of the integrated component (8) or the plug base (9) in which the recesses (10) for receiving the T-shaped extensions (7) of the resilient bracket are provided are chamfered towards the heat sink side.

**Revendications**

1. Dispositif pour fixer de façon amovible un radiateur sur un module intégré, notamment sur un module dans lequel les bornes sont disposées sur la face inférieure et s'étendent jusqu'à son bord, avec utilisation d'un étrier élastique cintré en forme de U, qui présente en position médiane une ouverture (2) qui correspond sensiblement au diamètre de l'âme du radiateur (3) afin d'entourer le radiateur entre les ailettes de refroidissement, caractérisé en ce que l'étrier élastique possède au moins une fente (4) permettant d'écarter unilatéralement l'étrier élastique lors de l'introduction entre les ailettes de refroidissement du radiateur, ainsi que des languettes d'écartement (5) qui s'étendent latéralement vers le haut.

2. Dispositif selon la revendication 1, caractérisé en ce que les languettes d'écartement (5) sont formées par des fentes en forme de U (6) ménagées dans l'étrier élastique (1).

3. Dispositif selon la revendication 1, caractérisé par deux paires d'appendices en forme de T (7), disposés sur les extrémités des branches de l'étrier élastique en forme de U, et par des ouvertures (10) corrrespondantes disposées sur les côtés du module intégré (8) ou du socle à enfichage (9) pour le module.

4. Dispositif selon l'une des revendications 1 à 3, caractérisé par un mécanisme (11) disposé sur la partie séparable de l'étrier élastique et servant à la fermeture de l'étrier élastique.

5. Dispositif selon la revendication 4, caractérisé par un appendice en forme de L (12) disposé sur une branche de la partie séparable de l'étrier élastique (1) et par une ouverture en forme de L (13) ménagée dans l'autre branche de la partie séparable de l'étrier élastique, qui, après l'introduction de l'étrier élastique entre les ailettes du radiateur, s'interpénètrent et maintiennent en position de fermeture la partie séparable de l'étrier élastique.

6. Dispositif selon l'une des revendications 1 ou 2, caractérisé par une fente en forme de U (14) ménagée dans la languette d'écartement du côté non séparable de l'étrier élastique, qui s'étend parallèlement aux bords de la languette d'écartement (5), ainsi que par une fente (15) qui s'étend en position médiane, de l'extrémité correspondante de l'étrier élastique jusqu'à la fente en forme de U (14).

7. Dispositif selon l'une des revendications 1 à 6, caractérisé en ce que la partie médiane de l'étrier élastique en forme de U (1) est cintrée en direction du module intégré.

8. Dispositif selon la revendication 3, caractérisé en ce que les appendices en forme de T (7) prévus aux extrémités des branches de l'étrier élastique sont faiblement cintrées en direction du module intégré (8).

9. Dispositif selon l'une des revendications 1 à 8, caractérisé en ce que les bords supérieurs (16) de ceux des côtés du module intégré (8) ou du socle à enfichage (9), dans lesquels sont prévues les ouvertures (10) pour recevoir les appendices en forme de T (7) de l'étrier élastique, sont biseautés vers le bord du radiateur.

# FIG 1

# FIG 2

# FIG 3

FIG 4

FIG 5

FIG 6